# EUROPEAN PATENT APPLICATION

(11) **EP 4 604 169 A1**
(43) Date of publication of application: **20.08.2025**
(21) Application number: 23877021.8
(22) Date of filing: 29.08.2023
(51) Int. Cl.: H01L 21/02, H01L 21/304, H01L 21/52, H01L 33/00

(54) **BONDING DEFECT REMOVAL METHOD FOR BONDED WAFER AND METHOD FOR MANUFACTURING BONDED WAFER**

(30) Priority: 12.10.2022 JP 2022164218
(71) Applicant: Shin-Etsu Handotai Co., Ltd., Tokyo 100-0004 (JP)
(72) Inventor: ISHIZAKI, Jun-ya, Annaka-shi, Gunma 379-0196 (JP); AKIYAMA, Tomohiro, Annaka-shi, Gunma 379-0196 (JP)
(74) Representative: Schicker, Silvia
(86) International application number: PCT/JP2023/031223
(87) International publication number: WO 2024/080013

(57) **Abstract**

The present invention is a method for removing a bonding failure portion in a bonded wafer, the method including removing the bonding failure portion in the bonded wafer which includes a light emitting device structure having an active layer made of (Al_{y}Ga1_{1-y}) ₓIn₁₋ₓP (0.4≤x≤0.6, 0≤y≤0.5), and is bonded to a transparent substrate, which transmits light of emission wavelength, by curing a thermosetting bonding member, in which the bonded wafer is introduced into a plasma atmosphere to remove the bonding failure portion where the thermosetting bonding member is insufficiently cured by selectively breaking. This provides a method for removing a bonding failure portion in a bonded wafer, which can remove a curing failure portion without using methods such as measurement in the bonded wafer in which a light emitting device structure having an AlGaInP-based active layer and a transparent substrate are bonded via a thermosetting bonding member.

## Description

### TECHNICAL FIELD

The present invention relates to a method for removing a bonding failure portion in a bonded wafer and a method for manufacturing a bonded wafer, in particular, relates to a method for removing a bonding failure portion in a bonded wafer having a light emitting device structure and a method for manufacturing a bonded wafer having a light emitting device structure.

### BACKGROUND ART

Arts are disclosed, in which LEDs are released from starting substrates by using laser lift-off(LLO) and transferred to substrates for mounting, and then transferred to drive substrates to realize micro light emitting diode displays (micro LED displays) (Patent Document 1). However, all of the above arts are for GaN-based LEDs, and disclosures of arts related to µ-LEDs using AlGaInP-based LEDs are few.

In order to realize micro LED devices by the LLO steps with the AlGaInP-based LEDs, transfer to sapphire substrates is required. Regarding arts for transferring the AlGaInP-based LEDs to sapphire substrates, prior arts such as Patent Document 2 are disclosed. However, the prior arts do not disclose measures for dealing with cases where partial curing failure are generated.

When oxygen is present during curing, benzocyclobutene (BCB) does not cure sufficiently at a designed temperature and a designed time, resulting in the curing failure. Accordingly, when curing treating, treatments are generally performed in a vacuum atmosphere or a nitrogen atmosphere. However, due to the nature of the treatment which involves stacking, bonding, and heating two wafers together, oxygen may remain at bonding interfaces.

For example, when unevenness on the surface after applying BCB is significant and oxygen cannot be sufficiently removed before bonding or the oxygen cannot be sufficiently evacuated, then oxygen remains on the surface. The remaining oxygen causes cross-linking failure in BCB, resulting in generating the curing failure.

Although the curing failure portions of BCB can be determined by inspecting curing rates by FTIR and the like, the curing failure portions delaminate successively in subsequent steps and delaminated fragments cause damage to good portions or contaminate apparatuses; therefore, it is necessary to remove the failure portions before proceeding to the subsequent steps.

However, no prior art has been disclosed regarding a detection and removal of the curing failure portions.

### CITATION LIST

### PATENT LITERATURE

Patent Document 1: JP 2020-521181 A
Patent Document 2: JP 2022-013203 A

### SUMMARY OF INVENTION

### TECHNICAL PROBLEM

The present invention has been made in view of the above-described problem. An object of the present invention is to provide a method for removing a bonding failure portion in a bonded wafer, which can remove a curing failure portion without using methods such as measurement in the bonded wafer in which a light emitting device structure having an AlGaInP-based active layer and a transparent substrate are bonded via a thermosetting bonding member, and provides a method for manufacturing such a bonded wafer.

### SOLUTION TO PROBLEM

To achieve the object, the present invention provides a method for removing a bonding failure portion in a bonded wafer, the method comprising removing the bonding failure portion in the bonded wafer which comprises a light emitting device structure having an active layer made of (Al_{y}Ga_{1-y})ₓIn₁₋ₓP (0.4≤x≤0.6, 0≤y≤0.5), and is bonded to a transparent substrate, which transmits light of emission wavelength, by curing a thermosetting bonding member, wherein
the bonded wafer is introduced into a plasma atmosphere to remove the bonding failure portion where the thermosetting bonding member is insufficiently cured by selectively breaking.

In this way, by introducing the bonded wafer into the plasma atmosphere and selectively breaking the insufficiently cured bonding failure portion for removal, the bonding failure portion can be removed in a single process without requiring steps of two or more stages such as detection of the bonding failure portion and removal of the detected point.

In this case, the thermosetting bonding member is preferably benzocyclobutene.

The bonding failure portion can be more reliably removed by using the benzocyclobutene as the thermosetting bonding member.

Moreover, the transparent substrate is preferably sapphire or quartz.

These substrates can be suitably used as the transparent substrate, in particular, the substrates that have high transparency to a laser for LLO can be selected.

In addition, the plasma atmosphere is preferably a plasma generated from a gas containing any one or more of oxygen, nitrogen, argon, helium, or hydrogen in a plasma-generating apparatus having a barrel-type or a parallel plate-type electrode structure.

By using such a plasma atmosphere, the failure portion can be removed more easily and reliably.

Moreover, an apparatus that generates the plasma atmosphere is preferably an RIE (Reactive Ion Etching) apparatus, an ICP (Inductively Coupled Plasma) apparatus, a plasma CVD apparatus, an ashing apparatus, or a sputtering apparatus.

As for the apparatus to generate the atmosphere used in the present invention, these plasma-generating apparatuses can be suitably used.

Moreover, the present invention provides a method for manufacturing a bonded wafer, the method comprising the steps of:
providing an epitaxial wafer including a light emitting device structure having an active layer made of (Al_{y}Ga1_{1-y}) ₓIn₁₋ₓP (0.4≤x≤0.6, 0≤y≤0.5) and a transparent substrate that transmits light of emission wavelength in the light emitting device structure; and
bonding the epitaxial wafer and the transparent substrate via a thermosetting bonding member to produce a bonded wafer by curing the thermosetting bonding member for bonding, wherein
the method further comprises a step of removing a bonding failure portion where the thermosetting bonding member is insufficiently cured by selectively breaking, after curing the thermosetting bonding member and then introducing the bonded wafer into a plasma atmosphere.

Such a method for manufacturing a bonded wafer enables removing the insufficiently cured bonding failure portion by introducing the bonded wafer into the plasma atmosphere and selectively breaking the portion. Consequently, this method for manufacturing a bonded wafer enables removing the bonding failure portion in a single process without requiring steps of two or more stages such as detection of the bonding failure portion and removal of the detected point.

In this case, the thermosetting bonding member is preferably benzocyclobutene.

The bonded wafer can be manufactured, in which the bonding failure portion is more reliably removed, by using the benzocyclobutene as the thermosetting bonding member.

Moreover, the transparent substrate is preferably sapphire or quartz.

These substrates can be suitably used as the transparent substrate, in particular, the substrates that have high transparency to a laser for LLO can be selected.

In addition, the plasma atmosphere is preferably a plasma generated from a gas containing any one or more of oxygen, nitrogen, argon, helium, or hydrogen in a plasma-generating apparatus having a barrel-type or a parallel plate-type electrode structure.

By using such a plasma atmosphere, the bonded wafer can be manufactured, in which the failure portion can be removed more easily and reliably.

Moreover, an apparatus that generates the plasma atmosphere is preferably an RIE (Reactive Ion Etching) apparatus, an ICP (Inductively Coupled Plasma) apparatus, a plasma CVD apparatus, an ashing apparatus, or a sputtering apparatus.

In the inventive method for manufacturing a bonded wafer, these plasma-generating apparatuses can be suitably used as the apparatus to generate the plasma atmosphere.

### ADVANTAGEOUS EFFECTS OF INVENTION

The inventive method for removing a bonding failure portion in a bonded wafer and the inventive method for manufacturing a bonded wafer enable removing the insufficiently cured bonding failure portion by introducing the bonded wafer, in which the light emitting device structure having the AlGaInP-based active layer and the transparent substrate are bonded via the thermosetting bonding member, into the plasma atmosphere, and selectively breaking the portion. Thereby, the bonding failure portion can be removed in a single process without the need for steps of two or more stages such as detection of the bonding failure portion and removal of the detected point. That is, the curing failure portion in the bonded wafer can be removed without using methods such as measurement, thereby productivity is improved as well as a yield of products such as a micro-LED produced from the bonded wafer is improved.

### BRIEF DESCRIPTION OF DRAWINGS

FIG. 1 is a schematic cross-sectional view illustrating a part of a manufacturing step of a bonded wafer where a method for removing a bonding failure portion in a bonded wafer according to the present invention is applied.
FIG. 2 is a schematic cross-sectional view illustrating another part of a manufacturing step of a bonded wafer where a method for removing a bonding failure portion in a bonded wafer according to the present invention is applied.
FIG. 3 is a schematic cross-sectional view illustrating another part of a manufacturing step of a bonded wafer where a method for removing a bonding failure portion in a bonded wafer according to the present invention is applied.
FIG. 4 is a graph showing results in Examples and Comparative Example.

### DESCRIPTION OF EMBODIMENTS

Hereinafter, the present invention will be described in detail. However, the present invention is not limited thereto.

An aspect of the present invention is a method for removing a bonding failure portion in a bonded wafer, the method comprising removing the bonding failure portion in the bonded wafer which comprises a light emitting device structure having an active layer made of (Al_{y}Ga1_{1-y})ₓIn₁₋ₓP (0.4≤x≤0.6, 0≤y≤0.5), and is bonded to a transparent substrate, which transmits light of emission wavelength, by curing a thermosetting bonding member, wherein
the bonded wafer is introduced into a plasma atmosphere to remove the bonding failure portion where the thermosetting bonding member is insufficiently cured by selectively breaking.

In addition, another aspect of the present invention is a method for manufacturing a bonded wafer, the method comprising the steps of:
providing an epitaxial wafer including a light emitting device structure having an active layer made of (Al_{y}Ga_{1-y})xIn₁₋ₓP (0.4≤x≤0.6, 0≤y≤0.5) and a transparent substrate that transmits light of emission wavelength in the light emitting device structure; and
bonding the epitaxial wafer and the transparent substrate via a thermosetting bonding member to produce a bonded wafer by curing the thermosetting bonding member for bonding, wherein
the method further comprises a step of removing a bonding failure portion where the thermosetting bonding member is insufficiently cured by selectively breaking, after curing the thermosetting bonding member and then introducing the bonded wafer into a plasma atmosphere.

Hereinafter, the present invention will be described in detail with reference to the drawings. However, the present invention is not limited thereto. The following will describe embodiments of the present invention, exemplifying from the first embodiment to the fourth embodiment.

### (First Embodiment)

First, the first embodiment is described. The first embodiment is an example in which a plasma-generating apparatus is an ashing apparatus.

First, a bonded wafer is provided, which includes a light emitting device structure having an active layer made of (Al_{y}Ga_{1-y})ₓIn₁₋ₓP (0.4≤x≤0.6, 0≤y≤0.5) and a transparent substrate transmitting light of emission wavelength and being bonded by cured thermosetting bonding member. Provision of such a bonded wafer can be performed by the steps of providing an epitaxial wafer including the light emitting device structure having the active layer made of (Al_{y}Ga_{1-y})ₓIn₁₋ₓP (0.4≤x≤0.6, 0≤y≤0.5), and the transparent substrate that transmits light of emission wavelength in the light emitting device structure, and bonding the epitaxial wafer and the transparent substrate via the thermosetting bonding member to manufacture a bonded wafer by curing the thermosetting bonding member for bonding. Specifically, such a bonded wafer can be manufactured as follows.

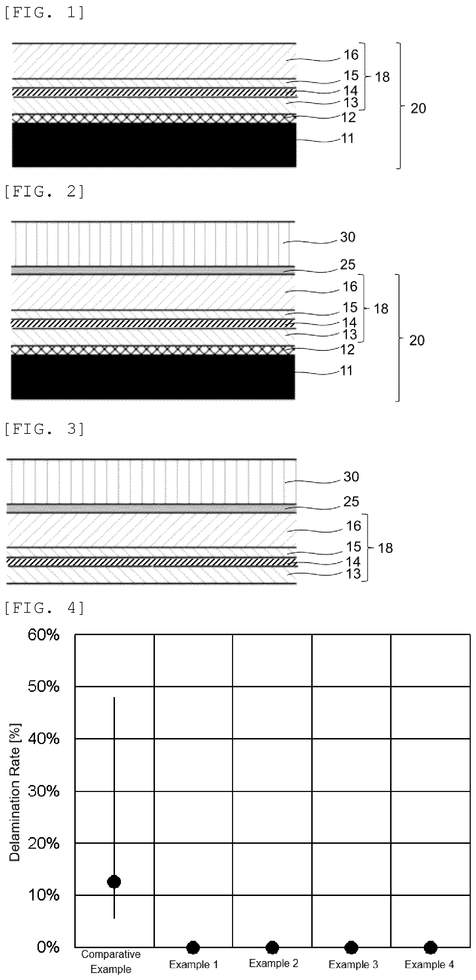

To begin with, as shown in FIG. 1, an etching stop layer 12 is epitaxially grown on a first conductivity-type starting substrate 11 made of, for example, GaAs. The etching stop layer 12 can be formed, for example, after laminating a first conductivity-type GaAs buffer layer, followed by, e.g., growing a first conductivity-type GaₓIn₁₋ₓP (0.4≤x≤0.6) first etching stop layer of, e.g., 0.1 µm, and, for example, a first conductivity-type GaAs second etching stop layer of, e.g., 0.1 µm. Moreover, the epitaxial wafer 20 is provided with the light emitting device structure 18 as an epitaxial functional layer in which, for example, a first conductivity-type (Al_{y}Ga_{1-y})ₓIn₁₋ₓP (0.4≤x≤0.6, 0.6≤y≤1.0) first cladding layer 13 of, e.g., 1.0 µm, for example, a non-doped (Al_{y}Ga_{1-y})ₓIn₁₋ₓP (0.4≤x≤0.6, 0≤y≤0.5) active layer 14, for example, a second conductivity-type (Al_{y}Ga_{1-y})ₓIn₁₋ₓP (0.4≤x50.6, 0.6≤y≤1.0) second cladding layer 15 of, e.g., 1.0 µm, a second conductivity-type GaₓIn₁₋ₓP (0.5≤x≤1.0) intermediate layer (not shown) of, e.g., 0.1 µm, and, for example, a second conductivity-type GaP window layer 16 are sequentially grown on the etching stop layer 12. At this point, from the first cladding layer 13 to the second cladding layer 15 is referred to as a double-hetero (DH) structure portion (FIG. 1).

The film thicknesses exemplified above are just examples, and the film thickness is no more than a parameter to be changed according to the operating specifications of the device; therefore, the film thickness is not limited to the thickness described here. The case where both the first cladding layer 13 and the second cladding layer 15 have a thickness of 1.0 µm is exemplified, but rated current density in the micro-LED is smaller than that in a discrete LED with a larger size, and even when the film thickness is thinner than the above thickness, a function as the cladding layer is not compromised.

Moreover, the electrodes are formed as being in contact with the first cladding layer 13, thus it is suitable that the first cladding layer 13 has a thickness of 0.6 µm or more, considering metal diffusion during ohmic contact formation. A greater thickness than this is preferable and any greater thickness can be selected. However, when the thickness becomes too great, it is more likely to lead to a factor for increasing costs, reduced luminous efficiency during constant current drive, or decreased yield due to increased warp of the wafer. Thus, this thickness is preferably 10 µm or less.

When the second conductivity-type is p-type, an effective mass of holes is large, allowing the second cladding layer 15 having a thickness of, for example, even about 0.2 µm to function in the same way as in a thickness of 1.0 µm. Therefore, a thickness of 0.2 µm or more is preferable, and any greater thickness can be selected. However, when the thickness becomes too great, it is more likely to lead to a factor for increasing costs, reduced luminous efficiency during constant current drive, or decreased yield due to increased warp of the wafer. Thus, this thickness is preferably 10 µm or less.

Moreover, a concept includes that each layer is not a single composition layer, but has a layer of a plurality of compositions within a range of compositions shown in the example. Furthermore, a concept includes that levels of carrier concentrations are not uniform in each layer but the concentrations have a plurality of levels in each layer.

The active layer 14 may be composed of a single composition or may have a super-lattice structure where a plurality of barrier layers and active layers 14 are alternatively stacked. Both have similar functions and can be selected. The actions and effects of the present invention are the same regardless of which structure is selected.

In addition, the GaP window layer preferably has a thickness of greater than 5 µm and can be, for example, 6 µm. Note that the thickness is not limited to this thickness of 6 µm, for example, when the film thickness is in a range that is thinner than a short side length in device isolation, any film thickness can be selected.

Next, as shown in FIG. 2, benzocyclobutene (BCB), for example, is spin-coated as a thermosetting bonding member 25 on the epitaxial wafer 20. A transparent substrate 30 such as a sapphire wafer is then stacked thereon facing each other and bonded by thermocompression under a vacuum atmosphere. When BCB is coated by spin coating, a film thickness can be, for example, 0.6 µm. In this way, the bonded wafer can be manufactured by bonding the epitaxial wafer 20 and the transparent substrate 30 via the thermosetting bonding member 25 and curing the thermosetting bonding member 25 to bond therebetween.

Note that the atmosphere during the thermocompression is not limited to the vacuum atmosphere, and any atmosphere can be adopted as long as the atmosphere has the oxygen of 100 ppm or less. For example, the same effect can be obtained from a nitrogen atmosphere and an argon atmosphere, etc.

Moreover, the transparent substrate 30 is not limited to sapphire, and any material can be selected as long as transparency to laser light for LLO and flatness is guaranteed. Quartz can be selected other than sapphire.

Moreover, when BCB is used as the thermosetting bonding member 25, in addition to applying BCB in a layered shape, a photosensitive BCB can be used to pattern into an isolated island shape, a line shape, or other shapes, and a bonding step is then performed, leading to the same result being obtained.

Moreover, the thickness of the thermosetting bonding member 25 such as BCB is not limited to 0.6 µm and it is possible to be thinner than this thickness.

Next, as shown in FIG. 3, the starting substrate 11 (for example, the GaAs starting substrate) is removed by wet etching, and then the etching stop layer 12 is also removed. When the etching stop layer 12 includes the first etching stop layer and the second etching stop layer as described above, the removal of the etching stop layer 12 can be performed by first exposing the first etching stop layer by etching, then switching an etchant to remove the second etching stop layer, thereby exposing an epitaxial layer (the first cladding layer 13 in the light emitting device structure 18). In this way, the bonded wafer can be manufactured that retains only the double-hetero (DH) structure portion (the first cladding layer 13, the active layer 14, and the second cladding layer 15) and the window layer 16 (FIG. 3).

After providing the bonded wafer in this way, in the present invention, the bonded wafer is introduced into a plasma atmosphere, and an insufficiently cured bonding failure portion of the thermosetting bonding member 25 is removed by selectively breaking. That is, after curing the thermosetting bonding member 25, the bonded wafer is introduced into the plasma atmosphere, and the bonding failure portion where the thermosetting bonding member 25 is insufficiently cured is removed by selectively breaking. In this way, the bonded wafer can be manufactured, in which the bonding failure portion where the thermosetting bonding member 25 is insufficiently cured is selectively broken. In this case, preferably, the plasma atmosphere is a plasma generated from a gas containing any one or more of oxygen, nitrogen, argon, helium, or hydrogen in a plasma-generating apparatus having a barrel-type or a parallel plate-type electrode structure. Moreover, in the present invention, an apparatus that generates the plasma atmosphere can be an RIE (Reactive Ion Etching) apparatus, an ICP (Inductively Coupled Plasma) apparatus, a plasma CVD apparatus, an ashing apparatus, or a sputtering apparatus. In the first embodiment, an example in which the ashing apparatus is the plasma-generating apparatus is described.

A degree of vacuum of plasma atmosphere can be, for example, 100 [Pa], and oxygen is introduced at, for example, 100 sccm. Then, the bonded wafer is held for, e.g., 5 minutes in the atmosphere where the oxygen plasma is generated. The same effect can be obtained when the gas introduced is a mixture of any one or more of nitrogen, argon, helium, and hydrogen, in addition to oxygen, and then a plasma treatment is performed thereto. However, the mixture of oxygen and hydrogen among the above gases is excluded.

The plasma conditions described above are just examples and are not limited to the values described above. The pressure may be higher or lower than the exemplified pressure and can be freely set within a range such as 5 to 150 Pa. A gas flow rate is also a design element of plasma generation density, and the same effect can be obtained whether the flow rate is higher or lower than the exemplified flow rate as long as pressure control permits.

When the above treatment using the plasma is applied, charge-up and heating are generated by plasma at the curing failure portion of the thermosetting bonding member 25 such as BCB, causing the curing failure portion to expand and vaporize. As a result, the thermosetting bonding member where curing failure is generated (for example, BCB failure layer portion) and the epitaxial layer on the curing failure portion are both delaminated from a bonded substrate and the failure portion is removed.

After the plasma treatment, the wafer can be appropriately cleaned and other treatments. For example, while rotating the wafer, an organic solvent is sprayed thereon at a pressure of, for example, 5 kg/cm² to remove the delaminated BCB and epitaxial layer adhered to a surface of the wafer, and is then cleaned with pure water and spin-dry treated.

### (Second Embodiment)

Next, the second embodiment is described. The second embodiment is an example in which a plasma-generating apparatus is a plasma-generating apparatus having a parallel plate structure. The steps of manufacturing a bonded wafer, and a structure thereof are the same as in the first embodiment.

The bonded wafer is introduced into the plasma-generating apparatus having the parallel plate structure and a plasma treatment is performed under a reduced-pressure atmosphere. In this embodiment, the plasma-generating apparatus is an RIE apparatus, an ICP apparatus, or other apparatuses having a parallel plate structure. Furthermore, although a dry etching treatment is performed using the ICP apparatus also in subsequent steps to form a shape of a device, the plasma treatment of the present invention is performed before performing the subsequent steps, as described above.

The reduced-pressure atmosphere can be set to, for example, 1.0 [Pa], and oxygen is introduced at, for example, 50 sccm to generate oxygen plasma and perform treatment, thereby removing a failure portion. The same effect can be obtained when the gas introduced is a mixture of any one or more of nitrogen, argon, helium, and hydrogen, in addition to oxygen, and then the plasma treatment is performed thereto. However, the mixture of oxygen and hydrogen among the above gases is excluded.

Moreover, by introducing a reactive gas such as chlorine-based or fluorine-based gas other than the gases described above, the same effect can be obtained. However, in the case of these reactive gases, etching on a surface of a light emitting structure portion progresses even when using a weak plasma, thus it is preferable to use the gases described above.

Conditions for plasma are just examples and it is needless to say that the conditions are not limited to the values described above. The pressure may be higher or lower than the exemplified pressure and can be freely set within a range such as 0.1 to 10 Pa. A gas flow rate is also a design element of plasma generation density, and the same effect can be obtained whether the flow rate is higher or lower than the exemplified flow rate as long as pressure control permits.

After the plasma treatment, while rotating the wafer, an organic solvent is sprayed thereon at a pressure of, for example, 5 kg/cm² to remove the delaminated BCB and epitaxial layer adhered to a surface of the wafer, and is then cleaned with pure water and spin-dry treated.

### (Third Embodiment)

Next, the third embodiment is described. The third embodiment is an example in which a plasma-generating apparatus is a plasma CVD apparatus. The steps of manufacturing a bonded wafer, and a structure thereof are the same as in the first embodiment.

The bonded wafer is introduced into the plasma CVD apparatus and a plasma formation is performed under a reduced-pressure atmosphere, thereby removing a failure portion.

The reduced-pressure atmosphere can be set to, for example, 5.0 [Pa], TEOS (tetraethoxysilane) is introduced at, for example, 20 sccm, and oxygen is introduced at, for example, 50 sccm, thereby forming an SiO₂ film. Note that the film forming is not limited to the SiO₂ film and the same effect can be obtained by forming other silicon-containing films such as SiNx, phosphosilicate glass (PSG), and oxynitride (SiNxOx).

Conditions for plasma are just examples and are not limited to the values described above. Since the pressure is a parameter to determine a film-forming rate, the same effect can be obtained even when the pressure is higher or lower than the exemplified pressure. For example, the pressure can be freely set within a range of such as 0.1 to 10 Pa. A gas flow rate is also a design element of plasma generation density, in other words, it is a parameter of the film-forming rate; thus the same effect can be obtained whether the flow rate is higher or lower than the exemplified flow rate as long as pressure control permits.

After forming the film, the film can be removed by etching. For example, after forming the SiO₂ film, wet etching is performed using a hydrofluoric acid-based solution to remove the SiO₂ film.

### (Fourth Embodiment)

Next, the fourth embodiment is described. The fourth embodiment is an example in which a plasma-generating apparatus is a sputtering apparatus. The steps of manufacturing a bonded wafer, and a structure thereof are the same as in the first embodiment.

The bonded wafer is introduced into the sputtering apparatus and a sputtering forming is performed under a reduced-pressure atmosphere, thereby removing a failure portion.

The reduced-pressure atmosphere can be set to, for example, 2.0 [Pa], and an SiO₂ film is formed by applying RF plasma to an SiO₂ target. Note that the film forming is not limited to the SiO₂, the same effect can be obtained by forming other films that can be wet-etched, such as Ti, Al, TiO₂, ZnO, NbOx, SiNx, and TiNx.

Conditions for plasma are just examples and it is needless to say that the conditions are not limited to the values described above. Since the pressure is a parameter to determine a film-forming rate, the same effect can be obtained even when the pressure is higher or lower than the exemplified pressure. For example, the pressure can be freely set within a range of such as 0.1 to 10 Pa. A gas flow rate is also a design element of plasma generation density, in other words, it is a parameter of the film-forming rate; thus, the same effect can be obtained whether the flow rate is higher or lower than the exemplified flow rate as long as pressure control permits.

After forming the film, the film can be removed by etching. For example, after forming the SiO₂ film, wet etching is performed using a hydrofluoric acid-based solution to remove the SiO₂ film.

### EXAMPLE

Hereinafter, the present invention will be described in detail with reference to Examples and Comparative Example. However, the present invention is not limited thereto.

### (Example 1)

First, as shown in FIG. 1, an epitaxial wafer having a light emitting device structure was provided as an epitaxial function layer. Specifically, the wafer was provided as follows. To begin with, after stacking an n-type GaAs buffer layer on an n-type GaAs starting substrate 11, an n-type GaₓIn₁₋ₓP (0.4≤x≤0.6) first etching stop layer having a thickness of 0.1 µm and an n-type GaAs second etching stop layer having a thickness of 0.1 µm were formed to produce an etching stop layer 12. An n-type (Al_{y}Ga_{1-y})ₓIn₁₋ₓP (0.4≤x≤0.6, 0.6≤y≤1.0) first cladding layer 13 having a thickness of 1.0 µm, a non-doped (Al_{y}Ga_{1-y})ₓIn₁₋ₓP (0.4≤x≤0.6, 0≤y≤0.5) active layer 14, a p-type (Al_{y}Ga_{1-y})ₓIn₁₋ₓP (0.4≤x≤0.6, 0.6≤y≤1.0) second cladding layer 15 having a thickness of 1.0 µm, a p-type GaₓIn₁₋ₓP (0.5≤x≤1.0) intermediate layer (not shown) having a thickness of 0.1 µm, and a p-type GaP window layer 16 having a thickness of 0.6 µm were sequentially grown on the etching stop layer 12 to provide an epitaxial wafer 20 having the light emitting device structure as an epitaxial functional layer (FIG. 1).

Next, as shown in FIG. 2, benzocyclobutene (BCB) was spin-coated as a thermosetting bonding member 25 on the epitaxial wafer 20. A sapphire wafer, being a transparent substrate 30, was then stacked thereon facing each other and bonded by thermocompression under a vacuum atmosphere. When BCB was coated by spin coating, a designed film thickness was 0.6 µm.

Next, as shown in FIG. 3, the GaAs starting substrate 11 was removed by wet etching to expose the n-type first etching stop layer, then an etchant was switched to remove the second etching stop layer, thereby exposing the first cladding layer to remove the etching stop layer 12. In this way, an epitaxial bonded substrate was produced that retains only a DH layer and the window layer 16.

The bonded wafer was introduced into an ashing apparatus having a barrel structure, and oxygen was introduced at 100 sccm in a reduced-pressure atmosphere of 100 [Pa], subsequently, a plasma treatment was performed by holding the wafer in an atmosphere where oxygen plasma was generated for 5 minutes. In this way, the bonded wafer was manufactured in which an insufficiently cured bonding failure portion of thermosetting bonding member 25 was selectively broken.

After the plasma atmosphere treatment, while rotating the wafer, an organic solvent was sprayed thereon at a pressure of 5 kg/cm² to remove the delaminated BCB and epitaxial layer adhered to a surface of the wafer and was then cleaned with pure water and spin-dry treated to remove the bonding failure portion in the bonded wafer. Subsequently, a dry etching treatment to form a shape of a device was performed using the ICP apparatus as subsequent steps, and a state of delamination of the epitaxial layer during the dry etching treatment was investigated.

### (Example 2)

Provision of a bonded wafer up to FIG. 3 was performed in the same way as in Example 1. Removal of a bonding failure portion in the bonded wafer was performed under the same conditions as in Example 1 except that this bonded wafer was introduced into an RIE apparatus having a parallel plate structure, and oxygen was then introduced at 50 sccm in a reduced-pressure atmosphere of 1.0 [Pa], and then a plasma treatment was performed in an atmosphere where oxygen plasma was generated. Moreover, a state of delamination of the epitaxial layer during the dry etching treatment was investigated as in Example 1.

### (Example 3)

Provision of a bonded wafer up to FIG. 3 was performed in the same way as in Example 1. Removal of a bonding failure portion in the bonded wafer was performed under the same conditions as in Example 1 except that this bonded wafer was introduced into a plasma CVD apparatus, and TEOS was then introduced at 20 sccm and oxygen was introduced at 50 sccm in a reduced-pressure atmosphere of 5.0 [Pa] to form an SiO₂ film, and after film formation, the SiO₂ film was wet-etched using a hydrofluoric acid-based solution and removed. Moreover, a state of delamination of the epitaxial layer during the dry etching treatment was investigated as in Example 1.

### (Example 4)

Provision of a bonded wafer up to FIG. 3 was performed in the same way as in Example 1. Removal of a bonding failure portion in the bonded wafer was performed under the same conditions as in Example 1 except that this bonded wafer was introduced into a sputtering apparatus, and the SiO₂ film was formed by applying RF plasma to an SiO₂ target in a reduced-pressure atmosphere of 2.0 [Pa], and after film formation, the SiO₂ film was wet-etched using a hydrofluoric acid-based solution and removed. Moreover, a state of delamination of the epitaxial layer during the dry etching treatment was investigated as in Example 1.

### (Comparative Example)

A bonded wafer was manufactured in the same way as in Example 1, except that no plasma treatment was performed. Then, a dry etching treatment was performed using an ICP apparatus as subsequent steps to form a shape of a device without performing the plasma treatment. A state of delamination of an epitaxial layer during the dry etching treatment was then investigated.

### (Comparison of Examples and Comparative Example)

FIG. 4 shows a comparison of ratios of delaminated areas in epitaxial layers at an ICP treatment in the subsequent steps between Examples and Comparative Example. Since the degree of residual oxygen is not constant, the generation rate is also not constant. However, it is found that, in Examples, plasma treatments are performed before proceeding to ICP treatments in the subsequent steps in every case to remove failure portions, resulting in no new delamination of epitaxial layers generated at the ICP treatments in subsequent steps.

In addition, it is possible to measure a BCB curing rate by methods such as FTIR to identify a curing failure location itself. When it is only required to detect the curing failure potion, alternative methods can be available without using the present art. However, it is difficult to realize a removal after identifying the failure portion inexpensively. The BCB curing failure portion has an indeterminate form, for example, when it is attempted to identify the removal portion by a photolithography method using a photomask, etc., a new mask is required to provide thereto each time. As a result, a considerable cost is required. Moreover, after identifying the location using a measurement method, a selection of a different removal method itself increases treatment time and cost compared with the present art. In the present invention, the identification and removal of the failure portion are completed in a single step; therefore, this is a quick and simple method.

The present description includes the following embodiments.
[1]: A method for removing a bonding failure portion in a bonded wafer, the method comprising removing the bonding failure portion in the bonded wafer which comprises a light emitting device structure having an active layer made of (Al_{y}Ga_{1-y})ₓIn₁₋ₓP (0.4≤x≤0.6, 0≤y≤0.5), and is bonded to a transparent substrate, which transmits light of emission wavelength, by curing a thermosetting bonding member, wherein
   the bonded wafer is introduced into a plasma atmosphere to remove the bonding failure portion where the thermosetting bonding member is insufficiently cured by selectively breaking.
[2]: The method for removing a bonding failure portion in a bonded wafer according to the above [1], wherein
   the thermosetting bonding member is benzocyclobutene.
[3]: The method for removing a bonding failure portion in a bonded wafer according to the above [1] or [2], wherein
   the transparent substrate is sapphire or quartz.
[4]: The method for removing a bonding failure portion in a bonded wafer according to the above [1], [2], or [3], wherein
   the plasma atmosphere is a plasma generated from a gas containing any one or more of oxygen, nitrogen, argon, helium, or hydrogen in a plasma-generating apparatus having a barrel-type or a parallel plate-type electrode structure.
[5]: The method for removing a bonding failure portion in a bonded wafer according to the above [1], [2], [3], or [4], wherein
   an apparatus that generates the plasma atmosphere is an RIE (Reactive Ion Etching) apparatus, an ICP (Inductively Coupled Plasma) apparatus, a plasma CVD apparatus, an ashing apparatus, or a sputtering apparatus.
[6]: A method for manufacturing a bonded wafer, the method comprising the steps of:
   providing an epitaxial wafer including a light emitting device structure having an active layer made of (Al_{y}Ga_{1-y})ₓIn₁₋ₓP (0.4≤x≤0.6, 0≤y≤0.5) and a transparent substrate that transmits light of emission wavelength in the light emitting device structure; and
   bonding the epitaxial wafer and the transparent substrate via a thermosetting bonding member to produce a bonded wafer by curing the thermosetting bonding member for bonding, wherein
   the method further comprises a step of removing a bonding failure portion where the thermosetting bonding member is insufficiently cured by selectively breaking, after curing the thermosetting bonding member and then introducing the bonded wafer into a plasma atmosphere.
[7]: The method for manufacturing a bonded wafer according to the above [6], wherein
   the thermosetting bonding member is benzocyclobutene.
[8]: The method for manufacturing a bonded wafer according to the above [6] or [7], wherein
   the transparent substrate is sapphire or quartz.
[9]: The method for manufacturing a bonded wafer according to the [6], [7], or [8], wherein
   the plasma atmosphere is a plasma generated from a gas containing any one or more of oxygen, nitrogen, argon, helium, or hydrogen in a plasma-generating apparatus having a barrel-type or a parallel plate-type electrode structure.
[10]: The method for manufacturing a bonded wafer according to the [6], [7], [8], or [9], wherein
   an apparatus that generates the plasma atmosphere is an RIE (Reactive Ion Etching) apparatus, an ICP (Inductively Coupled Plasma) apparatus, a plasma CVD apparatus, an ashing apparatus, or a sputtering apparatus.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A method for removing a bonding failure portion in a bonded wafer, the method comprising removing the bonding failure portion in the bonded wafer which comprises a light emitting device structure having an active layer made of (Al_{y}Ga_{1-y})ₓIn₁₋ₓP (0.4≤x≤0.6, 0≤y≤0.5), and is bonded to a transparent substrate, which transmits light of emission wavelength, by curing a thermosetting bonding member, wherein
the bonded wafer is introduced into a plasma atmosphere to remove the bonding failure portion where the thermosetting bonding member is insufficiently cured by selectively breaking.

2. The method for removing a bonding failure portion in a bonded wafer according to claim 1, wherein
the thermosetting bonding member is benzocyclobutene.

3. The method for removing a bonding failure portion in a bonded wafer according to claim 1 or 2, wherein
the transparent substrate is sapphire or quartz.

4. The method for removing a bonding failure portion in a bonded wafer according to claim 1 or 2, wherein
the plasma atmosphere is a plasma generated from a gas containing any one or more of oxygen, nitrogen, argon, helium, or hydrogen in a plasma-generating apparatus having a barrel-type or a parallel plate-type electrode structure.

5. The method for removing a bonding failure portion in a bonded wafer according to claim 1 or 2, wherein
an apparatus that generates the plasma atmosphere is an RIE (Reactive Ion Etching) apparatus, an ICP (Inductively Coupled Plasma) apparatus, a plasma CVD apparatus, an ashing apparatus, or a sputtering apparatus.

6. A method for manufacturing a bonded wafer, the method comprising the steps of:
providing an epitaxial wafer including a light emitting device structure having an active layer made of (Al_{y}Ga_{1-y})ₓIn₁₋ₓP (0.4≤x≤0.6, 0≤y≤0.5) and a transparent substrate that transmits light of emission wavelength in the light emitting device structure; and
bonding the epitaxial wafer and the transparent substrate via a thermosetting bonding member to produce a bonded wafer by curing the thermosetting bonding member for bonding, wherein
the method further comprises a step of removing a bonding failure portion where the thermosetting bonding member is insufficiently cured by selectively breaking, after curing the thermosetting bonding member and then introducing the bonded wafer into a plasma atmosphere.

7. The method for manufacturing a bonded wafer according to claim 6, wherein
the thermosetting bonding member is benzocyclobutene.

8. The method for manufacturing a bonded wafer according to claim 6 or 7, wherein
the transparent substrate is sapphire or quartz.

9. The method for manufacturing a bonded wafer according to claim 6 or 7, wherein
the plasma atmosphere is a plasma generated from a gas containing any one or more of oxygen, nitrogen, argon, helium, or hydrogen in a plasma-generating apparatus having a barrel-type or a parallel plate-type electrode structure.

10. The method for manufacturing a bonded wafer according to claim 6 or 7, wherein
an apparatus that generates the plasma atmosphere is an RIE (Reactive Ion Etching) apparatus, an ICP (Inductively Coupled Plasma) apparatus, a plasma CVD apparatus, an ashing apparatus, or a sputtering apparatus.
